(19) **Europäisches Patentamt**

**European Patent Office**

**Office européen des brevets**

(11) **EP 0 673 071 B1**

(12) **EUROPEAN PATENT SPECIFICATION**

(45) Date of publication and mention
of the grant of the patent:
**14.08.2002 Bulletin 2002/33**

(51) Int Cl.⁷: **H01L 27/115**, G11C 16/04

(21) Application number: **95301607.8**

(22) Date of filing: **10.03.1995**

(54) **Flash EEPROM and EPROM arrays**

Flash EEPROM und EPROM-Anordnungen

Mémoire flash EEPROM et matrices EPROM

(84) Designated Contracting States:
**DE FR GB IT**

(30) Priority: **11.03.1994 US 212176**
**11.03.1994 US 212165**

(43) Date of publication of application:
**20.09.1995 Bulletin 1995/38**

(73) Proprietor: **STMicroelectronics, Inc.**
**Carrollton Texas 75006 (US)**

(72) Inventors:
• **Anirban, Roy**
**Fremont, CA 94538 (US)**
• **Reza, Kazerounian**
**Alameda, CA 94501 (US)**
• **Irani, Rustom F.**
**Santa Clara, CA 95050 (US)**
• **Eitan, Boaz**
**Ra'anana, 43219 (IL)**

(74) Representative: **Driver, Virginia Rozanne et al**
**Page White & Farrer**
**54 Doughty Street**
**London WC1N 2LS (GB)**

(56) References cited:
**EP-A- 0 419 663**   **EP-A- 0 573 169**
**US-A- 5 151 375**   **US-A- 5 204 835**

• **PATENT ABSTRACTS OF JAPAN vol. 007 no.
103 (E-173) ,6 May 1983 & JP-A-58 025261
(NIPPON DENKI KK) 15 February 1983,**
• **PROCEEDINGS OF THE SYMPOSIUM ON VLSI
CIRCUITS, OISO, JP., MAY 30 - JUNE 1, 1991, no.
SYMP. 5, 30 May 1991 INSTITUTE OF
ELECTRICAL AND ELECTRONICS ENGINEERS,
pages 83-84, XP 000299478 KAMMERER W ET
AL 'A NEW VIRTUAL GROUND ARRAY
ARCHITECTURE FOR VERY HIGH SPEED, HIGH
DENSITY EPROMS'**

## Description

The present invention relates to electrically programmable read only memory (EPROM) arrays and to flash electrically erasable programmable read only memory (EEPROM) arrays generally and to alternating metal virtual ground EPROM and EEPROM arrays in particular.

The symbol Å used throughout the description denotes the unit Angstrom, which is well known in the art. 10Å are equivalent to 1nm, the appropriate SI unit.

EPROMs and electrically erasable programmable read only memory (EEPROM) arrays are basic building blocks of microprocessor systems. The EPROM and EEPROM arrays are comprised of a plurality of EPROM or EEPROM cells, each of which must be individually activatable.

Over the years, EPROM and EEPROM arrays have been continually improved, both in speed and in density, thereby to enable the microprocessor systems to run complicated programs at faster speeds. Different architectures provide different densities and different operating speeds, where typically an improvement in speed comes at a cost of reduced density, and vice versa.

Some types of EPROM arrays are common source arrays, virtual ground arrays, partitioned virtual ground arrays and alternate metal virtual ground arrays. Some types of EEPROM arrays are common source arrays and virtual ground arrays.

A virtual ground architecture is described in U.S. Patent 4,267,632. In the '632 patent, a first plurality of parallel spaced-apart, polycrystalline silicon ("polysilicon") lines is defined on one surface of, but insulated from, the silicon semiconductor substrate. Parallel, spaced apart doped regions ("diffusion bit lines") are formed in the silicon substrate between these first polysilicon ("poly 1") lines and in alignment with these lines. A second plurality of parallel, spaced-apart, polysilicon lines ("poly 2"), insulated from the poly 1 lines and the diffusion bit lines in the substrate, is formed perpendicular to the poly 1 lines and the diffusion bit lines. The poly 2 lines are then used as an etch mask to remove those portions of the poly 1 lines not covered by the poly 2 lines. The portions of the poly 1 lines remaining beneath the poly 2 lines are located between the diffusion bit lines and are the floating gates of the EPROM transistors, or cells.

While the '632 patent yields a plurality of floating gate devices in a relatively high density array, the cell size is still larger than desired. One reason for this is that one metal line is formed above each elongated diffusion bit line. Consequently, the size of the array is increased both by the widths of these metal lines and by the need to have numerous contacts (which of necessity are wider than the widths of the metal lines) between such metal lines and the underlying elongated diffusion bit lines. In addition, having a symmetrical transistor (source and drain are interchangeable) complicates the programming function in virtual ground arrays.

Furthermore, when reading a selected EPROM cell, the drain diffusion bit line is pre-charged to a predetermined level and the EPROM cell is read by removing charge from the drain line. It will be appreciated by those skilled in the art that the reading time is inversely dependent on the capacitance of the drain line and that the capacitance of each drain line is a function of the accumulation of the capacitance of the many EPROM cells attached to it.

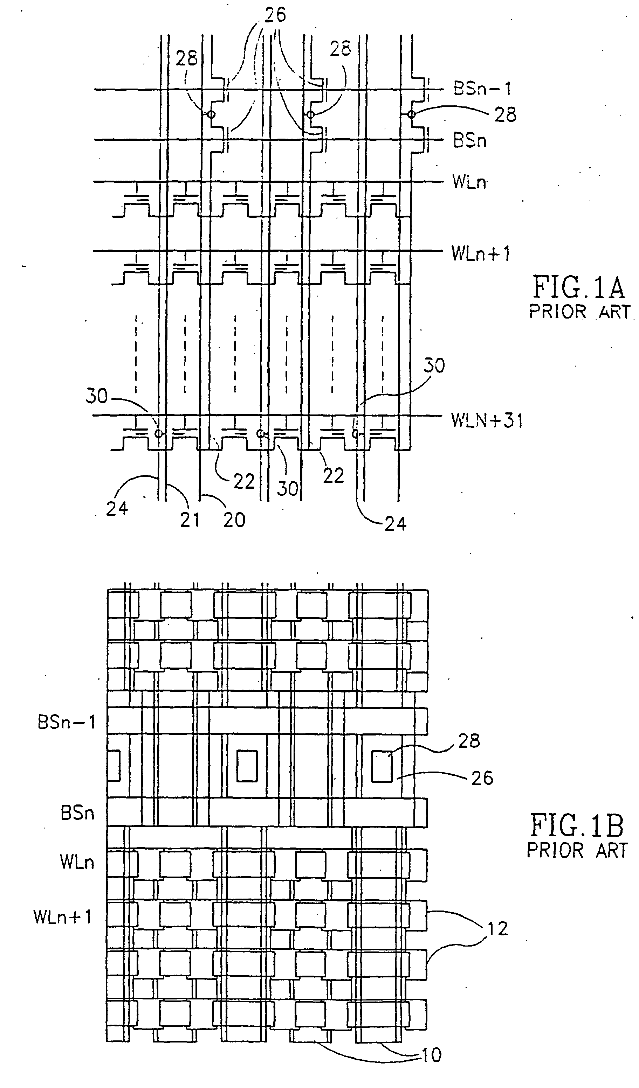

Reference is now made to Figs. 1A and 1B which illustrate a partitioned virtual ground architecture described in the article "A New Virtual Ground Array Architecture for Very High Speed, High Density EPROMs", presented at the 1991 VLSI Circuits Symposium, Japan by W. Kammerer, *et al.*, employees of the common assignees of the present invention.

In this architecture, there are two types of alternating diffusion bit lines, segmented ones 22 and continuous ones 24. The segmentation is provided in order to reduce bit line capacitance and achieve thereby a high operating speed.

Each diffusion bit line 22 or 24 is associated with a metal line 20 or 21, respectively, and a contact 28 or 30, respectively. The segmented diffusions 22 are connected to the metal lines 20 and contacts 28 via n-channel select transistors 26.

The n-channel transistors 26 and contacts 28 are located in one area of the array and the contacts 30 are placed in a second area of the array, thereby to minimize the amount of space they utilize. The pitch of the partitioned virtual ground architecture is limited by the width of the transistor 26 and, due to the staggering of the contacts 28 and 30, by one-half contact 28 or 30.

Typically, developments in EPROM manufacturing processes have not decreased the metal pitch as much as the pitch of the poly 1 and poly 2 layers. Since the metal pitch is considerably larger than the minimum dimension of an EPROM cell and since the partitioned virtual ground architecture has one metal line per cell, the metal pitch is the limiting factor in the size of each cell.

To achieve a maximal operating speed during a read operation, the sensed bit line must have the least capacitance and therefore, must be one of the segmented diffusions 22. As a result, for reading, the segmented diffusions 22 are dedicated read lines and the continuous diffusions 24 are dedicated source lines. However, for programming, the arrangement described hereinabove does not work since the n-channel transistors 26 cannot transfer the high voltage and high current required to program a cell. Therefore, during programming, the continuous diffusions 24 are dedicated to serve as high voltage terminals and the segmented diffusions 22 are dedicated to serve as source terminals.

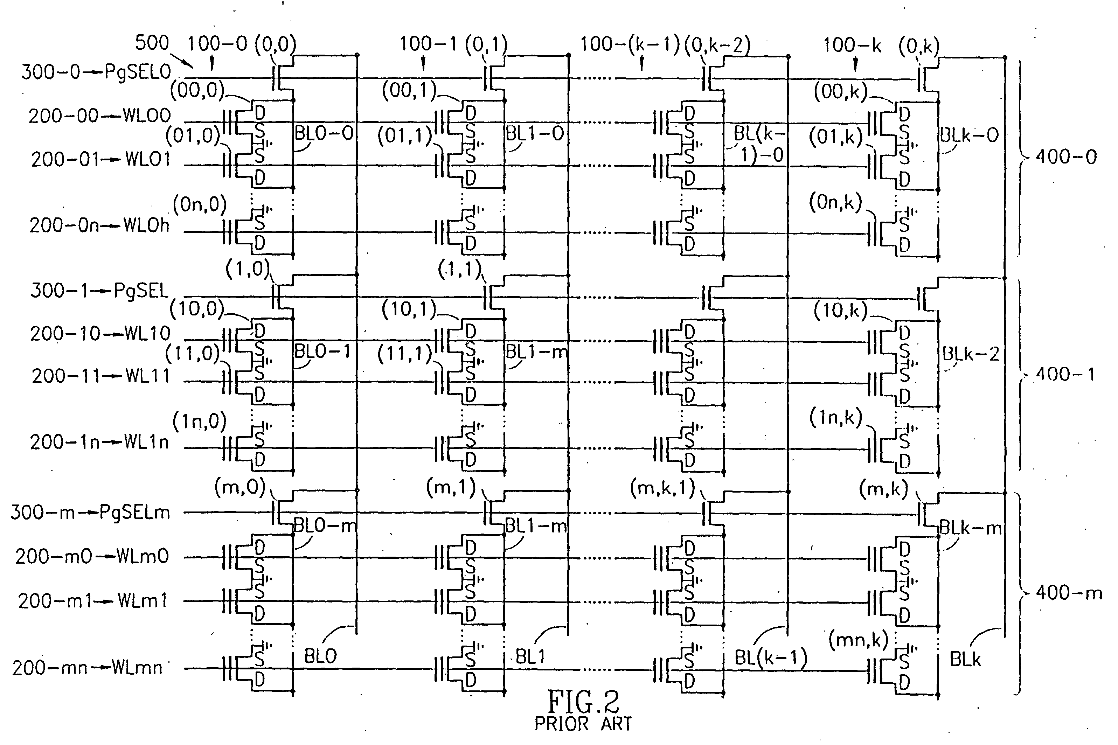

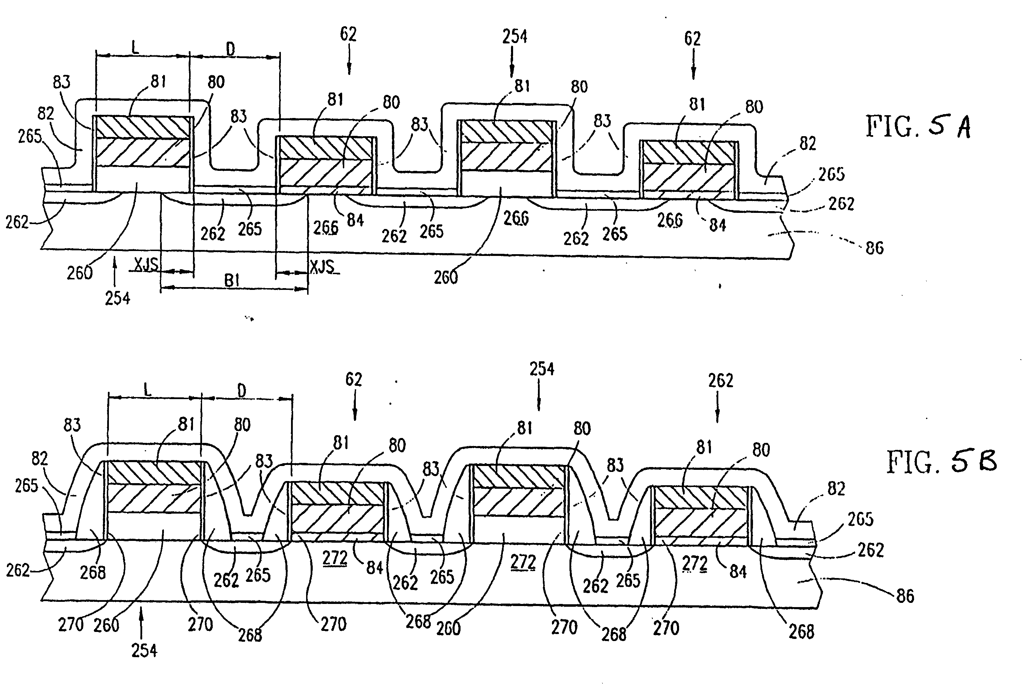

Segmentation is also utilized for separating a flash EEPROM array into a plurality of isolated EEPROM areas. This architecture is described in U.S. Patent 5,126,808, a copy of whose Fig. 5 is presented herein as Fig. 2 to whom reference is now made.

The segmented flash EEPROM architecture includes a plurality of EEPROM pages 100-k, each comprised of a multiplicity of flash EEPROM cells (ki,j), where k indicates the page number, i the row number and j the column number. The EEPROM cells (ki,j) are common ground array flash EEPROM transistors, wherein the sources S are connected to each other and to a ground signal.

The drain bit lines D are strapped by segmented metal lines BLk-j of a first metal layer. The metal line segments BLk-j are the local bit lines. The segmented metal lines of a page k are connected to continuous second metal lines BLk, which are global bit lines, through n-channel select transistors (i,j). Due to the use of the local bit lines, only one local block k is connected to the global bit line at any one time. If there are eight local blocks and bit lines, this segmentation reduces the bit line capacitance by a factor of 8.

However, before an EPROM or EEPROM cell can be read, its drain must be pre-charged to a certain level. If no voltage is applied to a page of an EPROM or EEPROM array, the level of charge will slowly decay. Therefore, in the flash EEPROM architecture of U.S. Patent 5,126,808, each page must first be pre-charged before the data stored therein can be sensed. This reduces the operating speed.

The flash EEPROM architecture described in U.S. Patent 5,126,808 has one metal line and one contact for every diffusion bit line. Thus, the area of the flash EEPROM array of U.S. Patent 5,126,808 is large and is limited by the metal pitch.

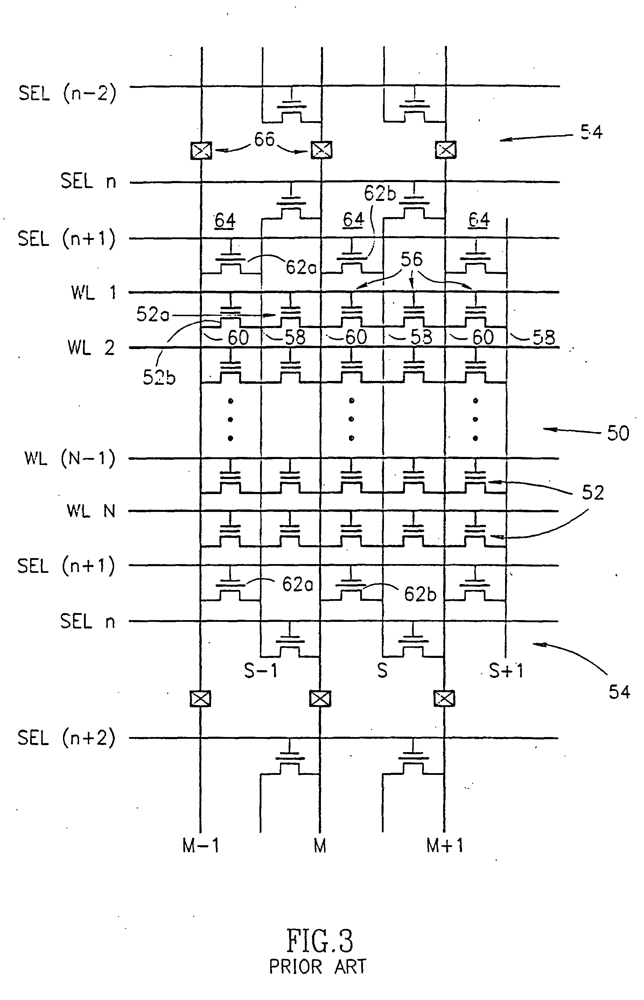

If there were only one metal line for every two diffusion bit lines and a contact, the limiting factor would not be the metal pitch, but rather the pitch of the polysilicon layers. This is known as a "poly pitch limited" architecture. One architecture which has only one such metal line is that of the alternating metal virtual ground EPROM array, described in U.S. Patents 5,204,835 and 5,151,375, assigned to the common assignee of the present invention, and illustrated in Fig. 3 to which reference is now made.

The EPROM array of U.S. Patents 5,151,375 and 5,204,835 comprises an EPROM area 50 comprising a plurality of EPROM transistors 52, or cells, surrounded by two "control areas" 54 comprising control elements, detailed hereinbelow.

In the EPROM area 50, each cell 52 comprises a gate 56, a source 58 and a drain 60. The sources 58 of a column of EPROM cells 52 together form non-metal-strapped, segmented diffusion bit lines, labeled S-1, S and S+1. The drains 60 of a column of EPROM cells 52 together form metal-strapped, continuous diffusion bit lines labeled M-1, M and M+1. Segmented bit lines S-1, S and S + 1 typically connect together N EPROM cells 52, where N is typically 64. The gates 56 of a row of cells are connected to one word line WLi.

Each control area 54 comprises select transistors 62, contacts 66 and selected lines SELn and SEL(n+1). Select transistors 62 are typically stacked gate transistors but can also be n-channel devices. One contact 66 is connected to each bit line M-1, M or M+ 1 in each control area 54.

A pair of select transistors 62 from the two control areas 54 controlling an EPROM area 50 are operative, when activated by the appropriate select lines SELn or SEL(n+1), to connect one segmented diffusion bit line S-1, S or S+1 to a neighbouring continuous diffusion bit line M-1, M or M +1.

In order to access the EPROM cell labeled 52a, the following lines are activated: word line WL1, select lines SEL(n+1) and bit lines M and M-1. Bit line M receives the drain voltage and bit line M-1 receives the source voltage, which is typically a ground voltage. The select transistors 62 which are activated by select lines SEL(n+1) transfer the source voltage from bit line M-1 to the segment S-1. Word line WL1 activates a row of EPROM cells and bit lines M and M-1 activate a column of cells, thereby activating only EPROM cell 52a, which sits at the intersection of the activated row and column. The output of the EPROM cell 52a is provided through the contact 66 which is connected to the appropriate bit line.

In order to access the EPROM cell labeled 52b, voltage is placed on word line WL1, select lines SELn and metal strapped bit lines M-1 and M. Metal strapped bit lines M-1 and M become the drain and source, respectively, wherein the source is transferred to segment S-1 through the select transistors 62a.

It is noted that the source is always transferred to the segment lines Sj. It can be seen that the metal strapped bit lines Mj act as sources whenever they are connected to a segment line and as drains otherwise.

It will further be appreciated that, when the select lines SEL(n+1) activate a row of select transistors 62, they connect each bit line Mj with a segmented bit line Sj. Thus, when reading EPROM cell 52a, metal strapped bit line M-1 is connected, through the select transistor labeled 62a, to the segmented bit line S-1. This transfers the source to bit line S-1. At the same time, metal strapped bit line M (the drain) is connected, through the select transistor labeled 62b, to the segmented bit line S. Thus, the capacitance of the drain line is the sum of capacitance of the metal strapped bit line M plus the capacitance of the segmented bit line S connected to it. The overall bit line capacitance in this architecture has no advantages or disadvantages relative to other prior art architectures. It has a smaller area but adds capacitance due to the fact that the diffusions are continuous across the array.

Therefore, although the alternating metal virtual ground architecture described in U.S. Patents 5,204,835 and 5,151,375 has a very high density, its operating speed is slower than desired, due to the extensive capacitance of the operative drain line.

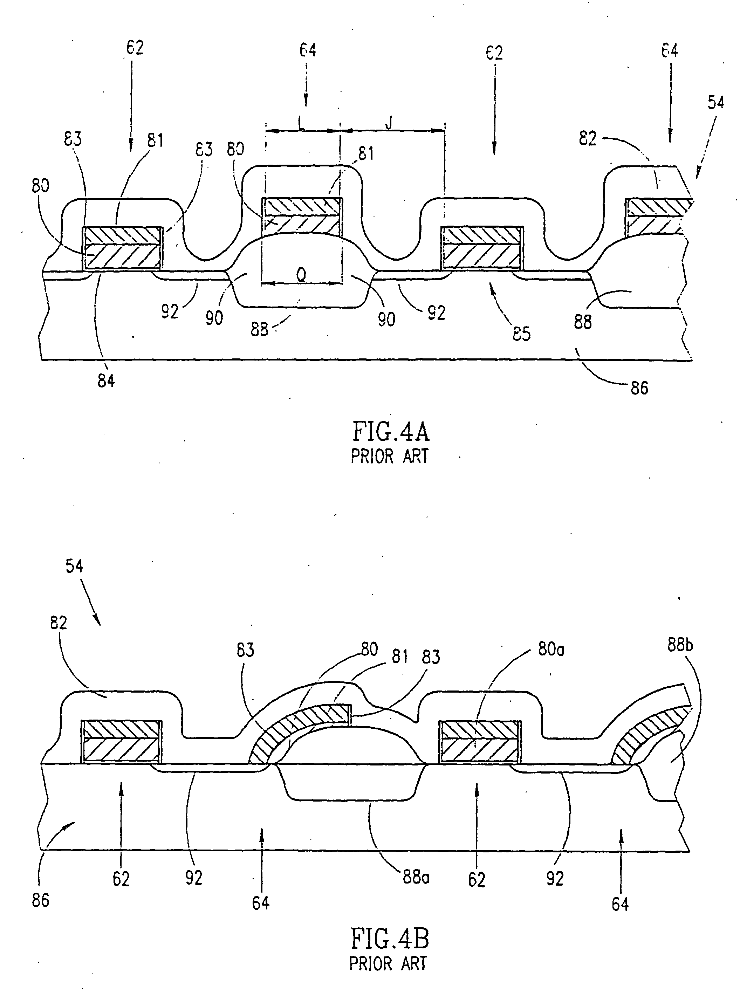

It is noted that, in order to ensure that the current only flows between the strapped and non-strapped bit lines M and S-1, respectively, through selected EPROM cell 52a, neighboring select transistors 62 are isolated from each other. This is illustrated in Fig. 3 by spaces 64 which, in reality, are field oxide isolation units 64 (shown in Fig. 4A). Units 64 isolate the select transistors 62 from each other such that no current flows between them.

Unfortunately, the isolation units 64 are not poly pitch limited, as shown in Figs. 4A and 4B to which reference is now made. Figs. 4A and 4B are schematic cross-sectional views of one control area 54 having a few isolation units 64 and select transistors 62. Figs. 4A and 4B are schematic cross-sectional views of one control area 54 having a few isolation units 64 and select transistors 62.

The transistors 62 and isolation units 64 have very similar structures. Each comprise a strip 80 of poly 1, of width L, covered by a strip of poly 2, labeled 82. They each also typically comprise sandwich layers 81, located between the two poly layers, and side oxides 83. Each sandwich layer 81 comprises a poly-poly dielectric formed of an oxide-nitride-oxide (ONO) dielectric layer capped by a polysilicon and a nitride layer.

In the select transistors 62, the poly 1 strip 80 lies on a thin, gate oxide strip 84 laid on top of a semiconductor substrate 86 (the "wafer") formed of silicon. When the select transistor 62 is active, current flows through an area 85 under the gate oxide strip 84, known as the "channel".

In the isolation units 64, the poly 1 strip lies on top of a very thick, field oxide element 88, typically of a thickness of 5000Å or greater. This thickness is large enough to ensure that the isolation unit 64 generally does not leak current.

As can be seen, each field oxide element 88 is not completely coincident with its corresponding strip 80 of poly 1. In fact, the field oxide elements 88 extend beyond the poly 1 strips 80. These extensions are known as "oxide beaks", labeled 90, and their size varies with manufacturing variations. The oxide beaks 90 extend into the area of the bit lines and reduce their width. The remaining portions of diffusion bit lines are labeled 92.

The isolation units 64 are not poly pitch limited for at least two reasons, as described hereinbelow.

Firstly, in order to ensure complete isolation, the minimum feature width Q of the field oxide element layer 88 is typically wider than the poly width L. Additionally, the oxide beaks 90 extend beyond the minimum feature width Q, by an imprecisely controllable distance.

Secondly, the mask used to produce the poly 1 strips 80 is often misaligned with the mask used to produce the field oxide elements 88, causing the poly 1 strips 80 to be misplaced vis-a-vis the field oxide elements 88. The resultant cross-section is illustrated in Fig. 4B, wherein a poly 1 strip 80a is too close to a field oxide element 88a.

If poly 1 strip 80a is very close to field oxide element 88a, the material (typically arsenic) used to implant the bit line diffusions 92 will not reach the silicon of the wafer 86 and the bit line diffusion 92, in the area of the field oxide element 88a, will have a discontinuity. Therefore, no bit line diffusion 92 is shown between strip 80a and field oxide element 88a. The resultant select transistor 62 fails to electrically connect the metal-strapped bit line (M) to its neighboring segmented bit line (S).

If the space between poly 1 strip 80a and field oxide element 88a is such that some arsenic, but not enough, succeeds in implanting, the bit line diffusion 92 will be too narrow and will have a high resistance. The signal from a select transistor 62 having such a bit line will be weak during reading and the rate of programming will be slow.

Therefore, in the prior art, when determining a distance J between strips 80 of poly 1, the following was considered: a minimal spacing SPACE between the field oxide element 88 and the adjacent poly 1 strip 80 necessary to ensure successful implantation of the bit line diffusion 92, the expected size BEAK of the oxide beak, the expected variation OXIDE in the size of the oxide beak 90, the expected extent MISALIGN of the misalignment, and the expected variation ETCH in the width of the poly I caused by the poly 1 etch. The distance J is given as:

$$J > SPACE + BEAK + sqrt(OXIDE^2 + MISALIGN^2 + ETCH^2) \qquad (1)$$

where "sqrt" indicates the square root function. Table 1 lists the variables of equation for the 0.8um process such as is described in previously mentioned U.S. Patent 5,151,375 and for a smaller 0.5um process. The value of J provided is the minimal value of J.

Table 1:

| VALUES FOR VARIABLES OF EQUATION 1 (in μm) | | |
|---|---|---|
| Variable | 0.8μm process | 0.5μm process |
| SPACE | 0.35 | 0.3 |
| BEAK | 0.35 | 0.25 |
| OXIDE | 0.1 | 0.05 |
| MISALIGN | 0.3 | 0.2 |
| ETCH | 0.1 | 0.05 |
| Minimum J | 1.03 | 0.76 |
| Ideal Cell Size | 2.56 | 1.0 |
| Actual Width Between Cells | 1.0 | 0.6 |
| Actual Cell Size | 3.25 | 1.39 |
| Percentage Increase Between Ideal and Actual Pitch | 27% | 39% |

For an 0.8μm process, a J of 1.03μm is only 27% larger than the desired poly pitch of 0.8μm. However, for a 0.5μm process, a J of 0.76μm is an unacceptable increase of 39%. For the 0.5μm process, J is still large because, although the design rule for lithographic processes is less, the values for BEAK, OXIDE, MISALIGN and ETCH are not reduced accordingly. As can be seen, the variables BEAK, OXIDE, MISALIGN and ETCH limit the extent to which any design can truly become poly pitch limited.

It will be appreciated that the pitch of the cell along a row (the X pitch) is the same as the size required for the control area 54. Thus, the cell ceases to be poly pitch limited.

EP-A-0 573 163 describes an EPROM array comprising a first plurality of EPROM areas and a second plurality of control areas. Each control area comprises two rows, each with a plurality of first polysilicon strips, second polysilicon strips lying on top of these and field oxide and thin oxide elements under the first polysilicon strips.

It is an object of the present invention to provide a generally compact isolation scheme for the control area of an alternating metal ground architecture for an EPROM array thereby to provide a more closely packed EPROM architecture. In this respect the aim is for there to be no oxide beaks and no misalignment between the poly 1 strips and the oxide elements. Furthermore, the isolation elements of the present invention should have the same lithographic variation as the poly 1 strips.

There is therefore provided, in accordance with a first aspect of the present invention, an EPROM array formed of two areas, an EPROM area having a plurality of EPROM cells and a control area having select transistors and novel isolation units which are self-aligned. Each isolation unit comprises a thick oxide element over which an EPROM transistor, formed of poly 1 and poly 2 layers, is placed. The thick oxide element is etchable and self-aligned to the poly 1 layer.

Since the thickness of the thick oxide element is less than that of the field oxide elements of the prior art, the isolation units of the present invention leak some current. However, the thickness of the thick oxide is selected to ensure that the leakage of the isolation units is significantly smaller than a leakage between bit lines, as described in detail in the detailed description hereinbelow. A typical thickness is 1000 - 2000Å.

Because the thick oxide element is etched, there are no oxide beaks. Because the thick oxide element is etched at the same time as the poly 1 layer, the thick oxide element is self-aligned to the poly 1 layer, thereby avoiding misalignment problems and providing the isolation units with the same lithographic variation as the poly 1 layer.

In a further embodiment, spacers are additionally laid down next to the poly 1 strips. The spacers minimize the bit line width to that of the space between poly 1 strips.

There is also provided, in accordance with a second aspect of the present invention, an EPROM array including a plurality of columns each including: a) two columns of a first polysilicon layer, b) a virtual source aligned between said two columns of first polysilicon, c) an EPROM area and d) at least one control area. In the EPROM area there are a plurality of rows of second polysilicon lying on top of said first polysilicon columns which form, at the intersections thereof with the columns of first polysilicon, a first group and a second group of EPROM transistors. Each EPROM transistor in said first and second groups is connected to said virtual source. The control area includes two rows, each row including: a) a row of second polysilicon lying on top of and perpendicular to said columns of first polysilicon and b) alternating thick and thin oxide elements under said first polysilicon columns. The thick and thin oxide elements are self-aligned to the columns of first polysilicon and the intersection of the thick oxide and the first and second polysilicon form self-aligned thick oxide isolation units. First select transistors are formed at the intersection of thin oxide, the first polysilicon columns and one row of the second polysilicon in the control area. The first select transistors are connected between the virtual source and a first bit line which functions as a drain for the first group of EPROM transistors but as a source for the second group of EPROM transistors, Second select transistors are formed at the intersection of thin oxide, the first polysilicon columns and the other row of the second polysilicon in the control area. The second select transistors are connected between the virtual source and a second bit line which functions as a drain for the second group of EPROM transistors but as a source for the first group of EPROM transistors. The first and the second select transistors are arranged so that the second select transistor acts as a control transistor for each of the EPROM transistors in the first group of EPROM transistors and the first select transistor acts as a control transistor for each of the EPROM transistors in the second group of EPROM transistors.

There is also provided, in accordance with a further aspect of the present invention, a method of manufacturing the isolation units. The method includes the steps of a) creating areas of thick oxide and areas of thin oxide in the control areas, b) with a mask, laying down strips of first polysilicon over at least a part of each of the thick and thin oxide portions and c) etching the thick and thin oxide portions in accordance with the mask, thereby to align the thick and thin oxide portions with the strips of first polysilicon.

Additionally, the step of etching is preferably performed with a 20:1 etch process.

Finally, the method can also include, after the step of etching, the step of laying down a spacer next to the strips of first polysilicon.

For the avoidance of any doubt as to the meaning of the term EPROM transistor or EEPROM transistor as used herein, such terms are intended to refer to transistors which have at least a floating gate.

The present invention will be understood and appreciated more fully from the following detailed description taken in conjunction with the drawings in which:

Figs. 1A and 1B are circuit diagram and layout illustrations, respectively, of a prior art virtual ground EPROM architecture;

Fig. 2 is a circuit diagram illustration of a prior art segmented EEPROM architecture;

Fig. 3 is a circuit diagram illustration of a prior art alternating metal ground EPROM architecture;

Figs. 4A and 4B are schematic cross-sectional views of a control area of the prior art EPROM array of Fig. 3, wherein Fig. 4A illustrates aligned layers and Fig. 4B illustrates misaligned layers;

Figs. 5A and 5B are schematic cross-sectional views of two embodiments of a control area of an alternating metal virtual ground EPROM array having novel isolation units, constructed and operative in accordance with a preferred embodiment of the present invention;

Fig. 6 is a schematic circuit diagram illustration of the EPROM array having the control areas of Figs. 5A and 5B;

Fig. 7 is a graphical illustration of isolation performance during a read operation as a function of effective channel length and thickness of a thick oxide element forming part of the novel isolation unit of Figs. 5A and 5B;

Fig. 8 is a graphical illustration of leakage current during programming as a function of gate voltage for a plurality of unselected EPROM cells and two isolation units of the present invention having two different thicknesses;

Figs. 9A, 9B, 9C, 9D and 9E are schematic cross-sectional views of the control area of the EPROM array showing the fabrication process for the control areas of Figs. 5A and 5B; and

Fig. 10 is a layout illustration for the EPROM array of Fig. 6 showing part of a control and an EPROM area.

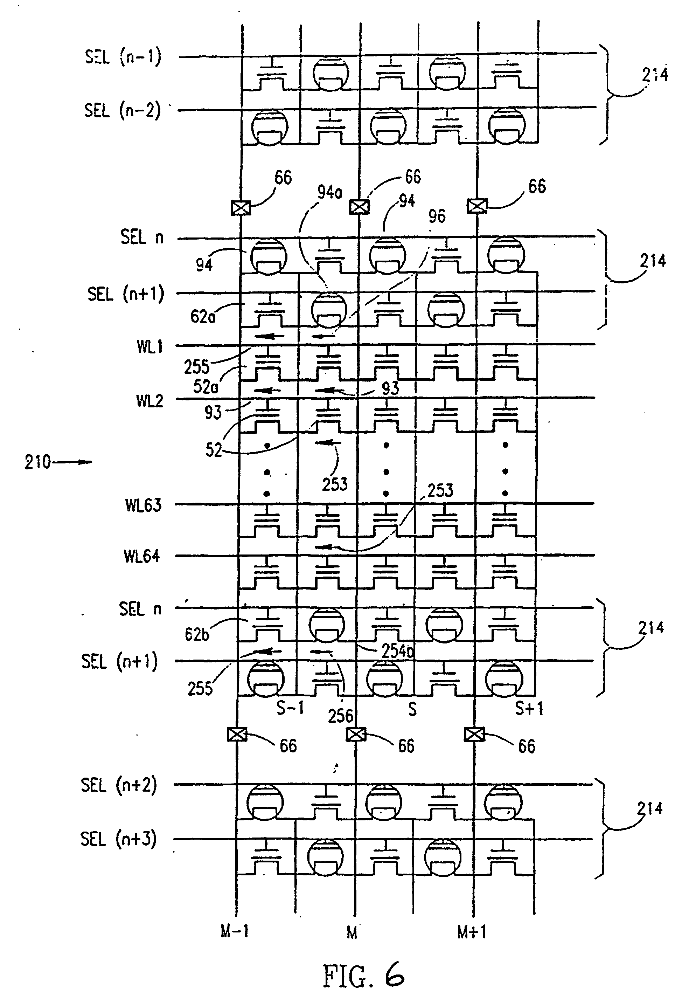

Reference is made to Figs. 5A, 5B and 6 which illustrate an EPROM array having novel, thick oxide isolation units, constructed and operative in accordance with the present invention. Figs. 5A and 5B are cross-sectional illustrations of two embodiments of the control area 214 of the EPROM array. Fig. 6 is a schematic circuit diagram illustration of the EPROM architecture.

The EPROM array of Figs. 5A, 5B and 6 is similar to that shown in Fig. 3, and described in U.S. Patents 5,204,835 and 5,151,375 except that the control area 214 comprises novel, thick oxide isolation units, labeled 254.

As shown in Figs. 5A and 5B, the thick oxide isolation units 254 of the present invention typically comprise a thick oxide element 260, typically having a thickness in the range of 1000 - 2000Å. The thick oxide element 260 replaces the field oxide element 88 (Fig. 4) of the prior art which is usually 9000Å thick. Those of the remaining elements which are similar to the prior art have similar reference numerals and will not be detailed herein except to note that the similar elements are the poly 1 and poly 2 strips 80 and 82, the sandwich layer 81, the side oxides 83 and the substrate 86.

In accordance with a preferred embodiment of the present invention, the thick oxide element 260 is etchable and is self-aligned to the poly 1 and sandwich strips 80 and 81, respectively. The maximal thickness of the thick oxide element 260 is determined by the etch process which, during etching, consumes the silicon of substrate 86 in a process known as "trenching". For the types of process currently envisioned, a trenching of 90 - 100Å is maximal.

The etching process preferably occurs after the poly 1 and sandwich strips 80 and 81, respectively, have been formed but before removal of the masks used to define them. The thick oxide element 260 is then etched with the same masks, thereby providing self-alignment to the poly 1 and sandwich strips 80 and 81, respectively.

It will be appreciated that, because of the self-aligned etching of thick oxide element 260, there are no oxide beaks nor any misalignment between the poly 1 layer 80 and the oxide layer below it. Therefore, in accordance with the present invention, the space, labeled D, between poly 1 lines 80 can have the same width as the lithographic design rule L, which is the width of the poly 1 lines 80. In other words, the architecture of the present invention is more poly pitch limited than that of the prior art.

Because the space D is generally consistently of width L, the bit lines, labeled 262 in Fig. 5A and Fig. 5B and covered by bit line oxides 265, can generally be implanted throughout the EPROM array. Thus, most of the select transistors 62 are operative, which improves the yield and performance of the integrated circuit.

As is known in the art, the implanted material of the bit lines generally diffuses to the side after implantation. Therefore, in the control area 214 shown in Fig. 6 the bit line 262 as a width B1 which is wider than the width D by an amount 2*XJS. If the width 2*XJS approaches the width L, the select transistor 62 will have no channel, labeled 266. This problem also occurs between the poly 1 lines in the EPROM array 50. If the width 2*XJS approaches the width L, the EPROM cells 52 will have no channel.

The embodiment of Fig. 5B solves this problem by including spacers 268 along the side 270 of the poly 1 lines 80. The spacers 268 are laid down before the bit line implant. As is known in the art, spacers 268 serve to reduce the space in which the bit lines 264 can implant. With the spacers 268 in place, when the bit line implants diffuse, they diffuse just past edges 270 of the poly 1 lines, as shown, thereby creating a channel 272 of a reasonable size.

It is noted that the maximal spacer width depends on the height of sides 270. For example, if the sides 270 are 1.2μm high, each spacer 268 will be 0.15μm wide and, since there are two spacers 268 per bit line, the total width utilized will be 0.3μm. Thus, in order to ensure that the bit lines can implant when utilizing spacers, for design rules much smaller than 0.5μm, the height of sides 270 should be minimized.

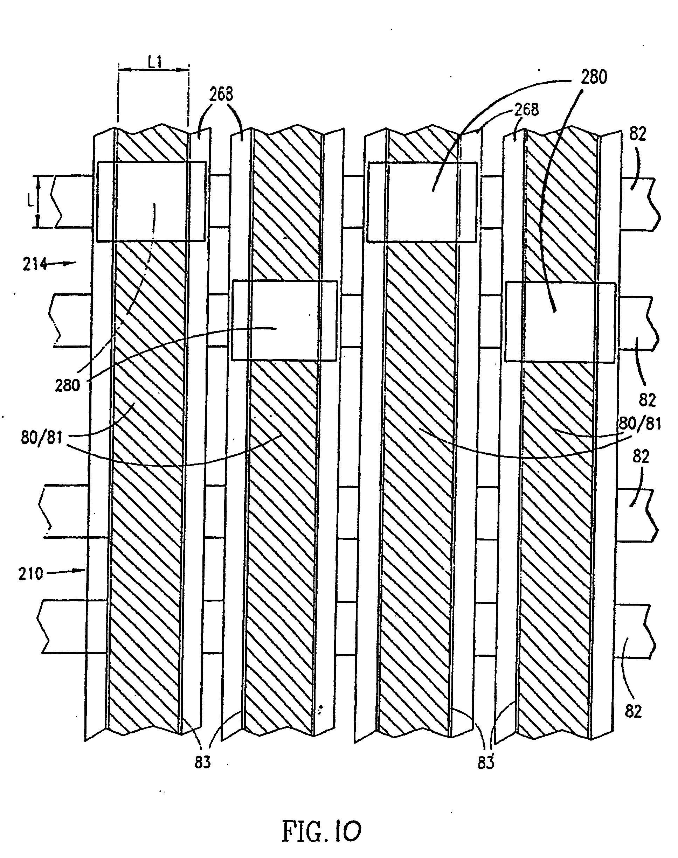

It is noted that, because the thick oxide element 260 is considerably thinner than the field oxide element 88 of the prior art, when a select transistor 62 is selected; its neighbouring isolation units 254 produce a weak current. This is illustrated in Fig. 11.

If EPROM cell 52a is selected, voltage is provided on the following lines: word line WL1, the two select lines SEL(n+1) and bit lines M and M-1. Significant current, indicated by thick arrows 255, will occur in select transistors 62a and 62b and in EPROM cell 52a. Some current, indicated by arrow 253, also flows through the unselected cell, labeled 52b, next to cell 52a and through the cells in the column of selected EPROM cell 52a. A leakage current in the isolation units 64, Ileak, is indicated by thin arrows 256.

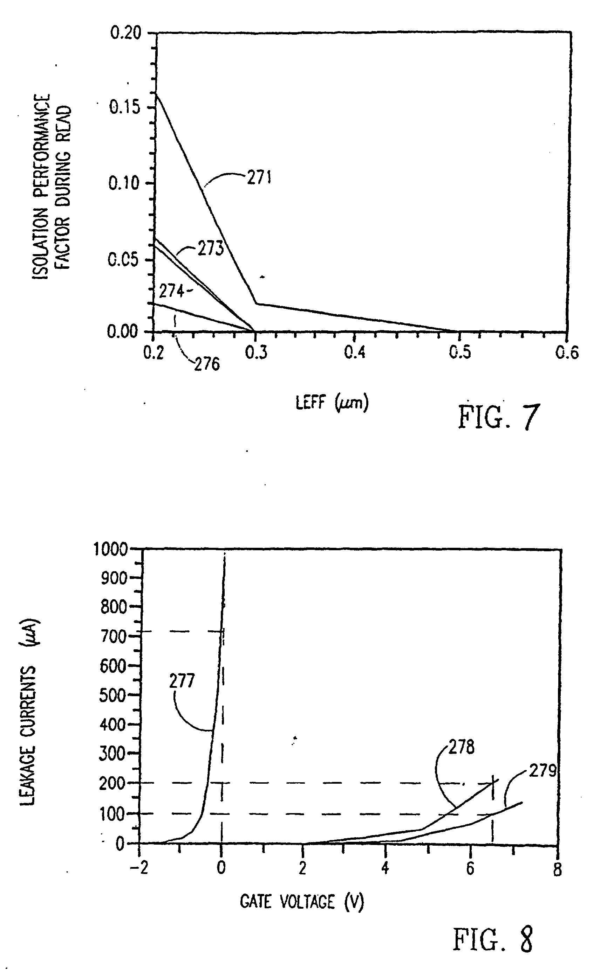

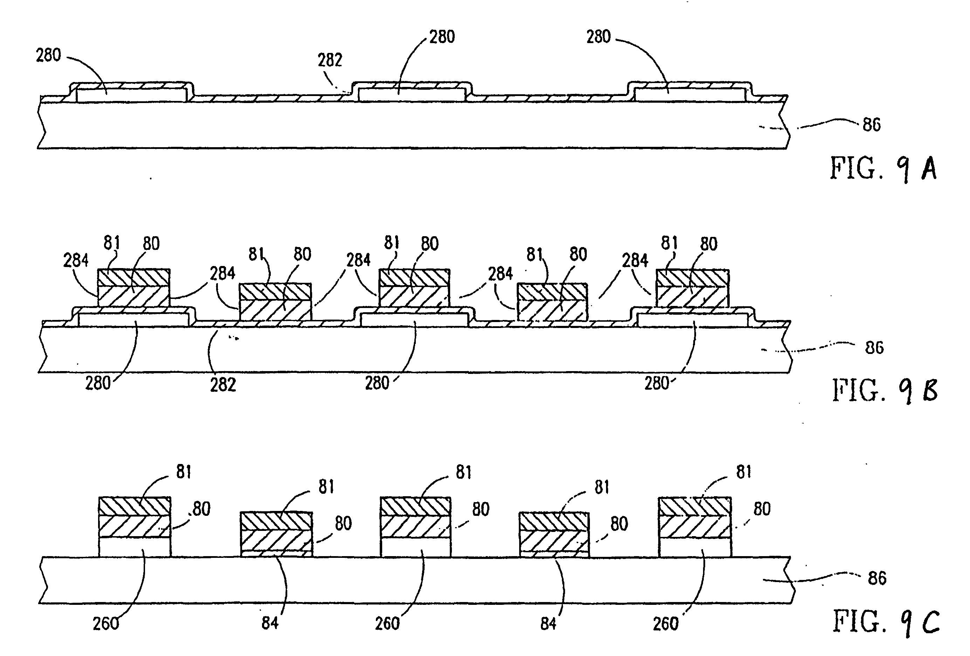

The extent of the leakage current, Ileak, is a function of the thickness, Tiso, of the thick oxide element 260. The thicker the thick oxide element 260 is, the less leakage current, Ileak, there will be; however, the thick oxide element 260 cannot be so thick that it cannot reasonably be etched. Therefore, the leakage current, Ileak, is accepted as long as it is significantly less than the current, Icell, in an activated but unprogrammed EPROM cell 52. Figs. 7 and 8, to which reference is now made, indicate the effect of the leakage current, Ileak, as a function of thickness Tiso.

The following parameters were utilized to calculate the graphs of Fig. 7:

$$\mathrm{VWL \doteq VSEL = 4.75V}$$
$$\mathrm{Weff(SEL) = 2*(Weff(cell))} \qquad\qquad (2)$$
$$\mathrm{Tprom = 150\mathring{A}}$$
$$\mathrm{Tono = 200\mathring{A}}$$

where VWL is the word line voltage, VSEL is the select line voltage, Weff is the effective channel width, "SEL" stands for select transistor 62 and "cell" stands for cell 52a, Tprom is the thickness of the oxide under poly 1 layer 80 and Tono is the thickness of the sandwich layer 81, all for a 0.5um design rule. The values of VWL and VSEL are typical for reading.

The following parameters were utilized to calculate the graphs of Fig. 8:

$$VWL = 12V$$

$$VSEL = 6.25V$$

$$VD = 7V$$

$$Weff(iso) = 2*(Weff(cell)) \qquad (3)$$

$$Tprom = 150\text{Å}$$

$$Tono = 200\text{Å}$$

where VD is the drain (bit line) voltage. The values of VWL and VSEL are typical for programming.

Fig. 7 illustrates an isolation performance factor, defined as the ratio Ileak/Icell, during the read operation for a programmed and an unprogrammed EPROM cell 52, as a function of effective channel length Leff. Four graphs 271, 273, 274 and 276 are shown, each having a different combination of thickness, Tiso, of the thick oxide element 260 and voltage Vs provided to the source of the cell 52a. Graph 271 has Tiso = 1000Å and Vs = 0, graph 273 has Tiso = 1290Å and Vs = 0, graph 274 has Tiso = 1000Å and Vs = 0.1V, and graph 276 has Tiso = 1290Å and Vs=0.1V.

Fig. 7 indicates that the isolation performance factor decreases with decreasing channel length and increasing thick oxide thickness. Since an acceptable isolation performance factor for reading, as dictated by design constraints, is less than 0.05 (i.e. the leakage current is 5% or less of the read current), for these parameters, Tiso should be greater than or equal to 1000Å.

Fig. 8 illustrates the extent of the leakage currents which occur during programming of the EPROM array of the present invention. These leakage currents are due to the "punchthrough" phenomenon and occur in the unselected EPROM cells 52 in the column of selected EPROM cell 52a.

Fig. 8 graphs leakage current versus gate voltage for the unselected cells 12 (graph 277) and for isolation units 254 having two thicknesses, Tiso, of 1000Å (graph 278) and 1250Å (graph 279). Fig. 8 indicates that the unselected cells leak significantly more than an isolation unit 254 having a thick oxide element 260 of either thickness. Therefore, the thickness of thick oxide element 260 is determined only by the isolation performance factor for reading, as shown in Fig. 7.

Figs. 7 and 8 indicate that the utilization of the thick oxide isolation units 254 does not significantly impair the operation of the EPROM array. It is noted that the thicknesses which provided good isolation performances in Figs. 7 and 8 are within the etchable range defined hereinabove. This is at least partially due to the fact that thick oxide element 260 is covered by a double poly structure which increases the effective oxide thickness by about 200Å.

It is further noted that the isolation performance factor is also a function of other factors not discussed herein, such as channel doping and the thickness Tprom of the dielectric, and therefore, must be optimized for a given process.

Reference is now made to Figs. 9A - 9E which illustrate the manufacturing process for the control area 214 of the EPROM array. Figs. 9A - 9E are cross-sectional views of the control area at different times during manufacturing.

In the following discussion, the process of etching a layer, which includes placing photoresist on the layer, placing a mask on the photoresist, etching wherever the mask is not and removing the photoresist, will not be detailed.

Except for the process steps related to the manufacture of the thick oxide element 260, the EPROM array is manufactured via a process similar to that outlined in U.S. Patent 5,151,375, whose teachings are already incorporated herein by reference.

Specifically, the first process steps are the standard initial CMOS process steps, including Nwell and field oxide element deposition.

In accordance with the present invention, a layer of isolation oxide, typically of 1200Å thick, is then laid down in the control area 214 of semiconductor substrate 86. The oxidation step is a dry or HCL oxidation, performed at a temperature of 900 - 1000°C.

The oxide is then etched with a mask to produce thick sections 280 (Fig. 9A) which are precursors to the thick oxide elements 260. Typically, the sections 280 are wider than oxide layers 260 and will be etched back in a later step.

A floating gate oxide layer 282 is grown next over the entire array, after the mask of the previous step is stripped. The floating gate oxide layer 282 is typically 150Å thick and is produced in accordance with standard processes. It is noted that the floating gate oxide layer is added to the thick oxide layer laid down previously. Portions of floating gate oxide layer 282 will later become the thin oxide layer 84.

The resultant side view is shown in Fig. 9A.

In accordance with standard EPROM process steps, a layer of poly 1 is laid down over the entire array and doped. Thereafter, the ONO layers of the sandwich layer 81 are laid down on top of poly 1 layer.

In accordance with U.S. Patent 5,151,375, the nitride and poly cap layers of the sandwich portion 81 are then laid down. Afterwards, the poly 1 and sandwich layers are etched in accordance with a poly 1 mask to produce the poly 1 and sandwich portions 80 and 81, respectively, in both the control and EPROM areas 214 and 210, respectively. It is noted that the poly 1 and sandwich layers in the periphery of the EPROM array are not etched. For the purpose of the following discussion, the poly 1 and sandwich portions 80 and 81, respectively, will herein be called a "poly 1 unit".

Fig. 9B illustrates the resultant side view of the control area 214. It is noted that, after the etch step, one poly 1 unit is located on top of and one between each thick section 280, wherein thick and floating gate oxide extends beyond edges 284 of the poly 1 units. The poly 1 units on top of the thick sections 280 will later become isolation units 254 and the other poly 1 units, lying on top of only floating gate oxide layer 282, will later become select transistors 62.

In accordance with a preferred embodiment of the present invention, the next step is a self-aligned oxide etch. The etch step utilizes the poly 1 mask (which has not yet been removed) and removes thereby the oxide between the poly 1 strips, including those portions of the thick sections 280 which extend beyond the edges 284 of the poly 1 units located thereon and of the floating gate oxide 282 not under a poly 1 unit. This step creates the thick oxide elements 260, comprised of thick sections 280 and some floating gate oxide 282, and the thin oxide layer 284.

A 20:1 etch, which minimizes trenching, is currently desirable. This can be produced by a model 9400 etcher manufactured by LAM Research Inc. of Fremont, California, USA.

The resultant side view of the self-aligned oxide etch step is illustrated in Fig. 9C.

In the next step, the poly 1 mask is removed and side oxide 83, typically of 150Å, is grown. The oxidation is a dry oxidation at 1000°C. The resultant side view is provided in Fig. 9D.

For the embodiment of Fig. 5B, a spacer material, such as silicon dioxide, is additionally deposited on top of the array in a standard low pressure chemical vapor deposition (LPCVD) process.

The spacer layer is then etched back with a dry anisotropic etch to attain a reasonable width. For example, for a 0.5µm design rule, a suitable width is 0.15µm. The resultant control area 214 is illustrated in cross-sectional view in Fig. 9E.

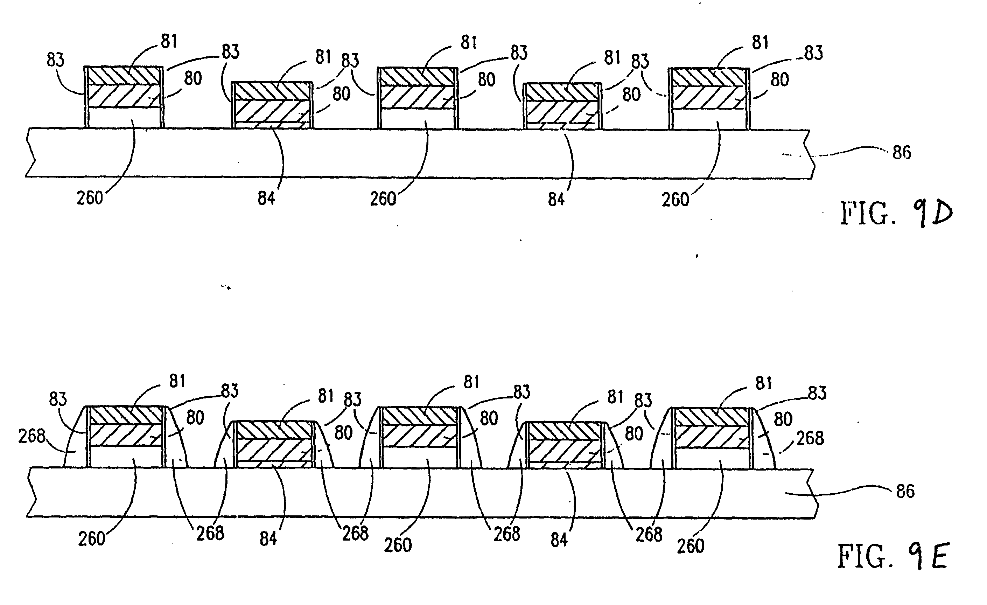

Fig. 10, to which reference is now briefly made, is a schematic layout of the layers described hereinabove, including the spacer layer for the embodiment of Fig. 5B. A portion of a control area 214 and an EPROM area 210 are illustrated, where the poly 1 layer 80, the thick oxides 280, the poly 2 layer 82 and the spacers 268 are shown. The layout is believed to be understandable with the description hereinabove and therefore, for the purposes of conciseness, will not be described in more detail.

The remaining process steps for both embodiments are the same as that of U.S. Patent 5,151,375. Specifically, the bit lines 262 or 264 (Fig. 5A) are implanted and grown in the spaces between poly 1 units, bit lines oxides 265, covering the implanted bit lines 262 or 264, are grown, the poly 2 layer 282 is laid down and etched, and the finishing steps are performed. The resultant cross-sections, corresponding to Figs. 9D and 9E, respectively, are provided in Figs. 5A and 5B.

It will be appreciated that the process described hereinabove produces thick oxide isolation units 254 which are self-aligned to the poly I units. The size of such transistors can easily be reduced since they are self-aligned.

It will be appreciated by persons skilled in the art that the present invention is not limited to what has been particularly shown and described hereinabove. Rather the scope of the present invention is defined only by the claims which follow:

## Claims

1.    An alternating metal virtual ground electrically programmable read-only memory (EPROM) array comprising:

    a. a first plurality of EPROM areas (180); and
    b. a second plurality of control areas (182), two per EPROM area (180), each control area comprising at least one row and each row comprising;

        i. a plurality of first polysilicon strips (80) extending in a first direction; and
        ii. a second polysilicon strip (82) lying on top of said first polysilicon strips (80) but extending in a second direction, perpendicular to the first direction;

    **characterised in that** thick oxide elements (260) and thin oxide elements (84) are arranged beneath and self-aligned to said first polysilicon strips (80), the thick oxide elements (260) alternating with the thin oxide elements (84) in the second direction; and **in that** the thin oxide elements (84) and the first (80) and second (82) polysilicon strips form a select transistor (112,114,116) and the thick oxide elements (260) and the first (80) and second (84) polysilicon strips form a self-aligned thick oxide isolation unit (254).

2. An EPROM array comprising:

    a. a plurality of columns each comprising :

    b. two polysilicon columns (80) of a first polysilicon layer;

    c. a virtual source (S) aligned between said two first polysilicon columns (80);

    d. in an EPROM area, a plurality of rows of second polysilicon (82) lying on top of said first polysilicon columns (80), and forming, at the intersections thereof with said first polysilicon columns (80) a first group and a second group of EPROM transistors (52), wherein each EPROM transistor (52) in said first and second groups is connected to said virtual source (S);

    e. at least one control area comprising two rows, each row comprising a layer of second polysilicon (82) lying on top of and perpendicular to said first polysilicon columns (80); **characterised in that** thick oxide elements (260) and thin oxide elements (84) are arranged beneath and self-aligned to said first polysilicon columns (80), the thick oxide elements (260) alternating with the thin oxide elements (84) in a first direction; **in that** the intersection of said thick oxide elements (260) and said first polysilicon columns (80) and second polysilicon (82) form self-aligned thick oxide isolation units (254); **in that** at the intersection with the thin oxide elements (84), said first polysilicon columns (80) and one row (SELn) of said second polysilicon in the control area forms first select transistors (62), said first select transistors being connected between said virtual source (S) and a first bit line which functions as a drain for said first group of EPROM transistors but as a source for said second group of EPROM transistors; **in that** at the intersection of the thin oxide elements (84), said first polysilicon columns (80) and the other row (SEL(n+1) of said second polysilicon in the control area forms second select transistors (62), said second select transistors being connected between said virtual source and a second bit line which functions as a drain for said second group of EPROM transistors but as a source for said first group of EPROM transistors; and **in that** said first and said second select transistors (62) are arranged so that the second select transistor (62) acts as a control transistor for each of the EPROM transistors (52) in said first group of EPROM transistors and the first select transistor (62) acts as a control transistor for each of the EPROM transistor (52) in said second group of EPROM transistors.

3. An EPROM array according to claim 1 or 2 wherein said thick oxide elements (260) have a thickness of 100 - 200 nm.

4. An EPROM array according to claim 1, 2 or 3 and also including spacers (268) alongside said first polysilicon strips or columns, respectively.

5. A method of manufacturing isolation units of an alternating metal virtual ground EPROM array, said array having EPROM areas and control areas, each control area comprising select transistors and isolation units located between neighbouring ones of the select transistors, the method **characterised by** comprising the steps of:

    a. depositing areas of thick oxide (260) and areas of thin oxide (84) in said control areas;

    b. with a mask, laying down strips of first polysilicon (150) over at least a part of each said thick oxide and thin oxide areas; and

    c. etching said thick and thin oxide areas in accordance with said mask thereby to align said thick and thin oxide areas with said strips of first polysilicon.

6. A method according to claim 5 and wherein said step of etching is performed with an etch process having a selectivity of 20:1.

7. A method according to claim 5 or 6 wherein said thick oxide area (260) has a thickness of 100-200 nm.

8. A method according to claim 5, 6 or 7 including, after the step of etching, the step of laying down a spacer (268) next to said strips of first polysilicon.

**Patentansprüche**

1. Elektrisch programmierbare, nur lesbare Speicheranordnung mit alternierender virtueller Metallerdung, bzw. EPROM-Anordnung mit alternierender bzw. abwechselnder virtueller Metallerdung, die aufweist:

    a. erste mehrere EPROM-Bereiche (180); und

b. zweite mehrere Steuerbereiche (182), zwei pro EPROM-Bereich (180), wobei jeder Steuerbereich zumindest eine Zeile aufweist und jede Zeile aufweist;

i. mehrere erste Polysiliziumstreifen (80), die sich in einer ersten Richtung erstrecken; und
ii. einen zweiten Polysiliziumstreifen (82), der auf dem oberen der ersten Polysiliziumstreifen (80) liegt, sich aber in einer zweiten Richtung senkrecht zu der ersten Richtung erstreckt;

**dadurch gekennzeichnet, dass** dicke Oxidelemente (260) mit dünnen Oxidelementen (84) unterhalb und selbstausgerichtet zu den ersten Polysiliziumstreifen (80) angeordnet sind, wobei die dicken Oxidelemente (260) mit den dünnen Oxidelementen (84) in der zweiten Richtung abwechseln; und dadurch, dass die dünnen Oxidelemente (84) und die ersten (80) und zweiten (82) Polysiliziumstreifen einen Auswähltransistor (112, 114, 116) bilden und die dicken Oxidelemente (260) und die ersten (80) und zweiten (84) Polysiliziumstreifen eine selbstausgerichtete dicke Oxidisolations- bzw. -trenneinheit (254) bilden.

2. EPROM-Anordnung, die aufweist:

a. mehrere Spalten, die jeweils aufweisen:
b. zwei Polysiliziumspalten (80) einer ersten Polysiliziumschicht;
c. eine virtuelle Source (S), die zwischen den zwei ersten Polysiliziumspalten (80) ausgerichtet bzw. angeordnet ist;
d. in einem EPROM-Bereich liegen mehrere Zeilen eines zweiten Polysiliziums (82) auf der oberen der ersten Polysiliziumspalten (80) und bilden an deren Überschneidungen mit den ersten Polysiliziumspalten (80) eine erste Gruppe und eine zweite Gruppe von EPROM-Transistoren (52), wobei jeder EPROM-Transistor (52) in den ersten und zweiten Gruppen an die virtuelle Source (S) angeschlossen ist;
e. zumindest einen Steuerbereich, der zwei Zeilen aufweist, wobei jede Zeile eine Schicht eines zweiten Polysilizium (82) aufweist, das auf der oberen der ersten Polysiliziumspalten (80) und senkrecht zu den ersten Polysiliziumspalten (80) liegt;

**dadurch gekennzeichnet, dass** dicke Oxidelemente (260) und dünne Oxidelemente (84) unter und selbst ausgerichtet zu den ersten Polysiliziumspalten (80) angeordnet sind, wobei die dicken Oxidelemente (260) mit den dünnen Oxidelementen (84) in einer ersten Richtung abwechseln; dass die Überschneidung der dicken Oxidelemente (260) und der ersten Polysiliziumspalten (80) und des zweiten Polysiliziums (82) selbstausgerichtete dicke Oxidisolations- bzw. -trenneinheiten (254) bildet, dass an der Überschneidung mit den dünnen Oxidelementen (84) die ersten Polysiliziumspalten (80) und eine Zeile (SELn) des zweiten Polysiliziums in dem Steuerbereich erste Auswähltransistoren (60) bilden, wobei die ersten Auswähltransistoren zwischen der virtuellen Source (S) und einer ersten Bitleitung angeschlossen sind, die als eine Drain für die erste Gruppe von EPROM-Transistoren, aber als eine Source für die zweite Gruppe von EPROM-Transistoren funktioniert; dass an der Überschneidung der dünnen Oxidelemente (84) die ersten Polysiliziumspalten (80) und die andere Zeile (SEL(n+1) eines zweiten Polysiliziums in dem Steuerbereich zweite Auswähltransistoren (62) bilden, wobei die zweiten Auswähltransistoren zwischen der virtuellen Source und einer zweiten Bitleitung angeschlossen sind, die als eine Drain für die zweite Gruppe von EPROM-Transistoren aber als eine Source für die erste Gruppe von EPROM-Transistoren funktionieren; und dass die ersten und die zweiten Auswähltransistoren (62) so angeordnet sind, dass der zweite Auswähltransistor (62) als ein Steuertransistor für jeden der EPROM-Transistoren (52) in der ersten Gruppe von EPROM-Transistoren wirkt und der erste Auswähltransistor (62) als ein Steuertransistor für jeden der EPROM-Transistoren (52) in der zweiten Gruppe von EPROM-Transistoren wirkt.

3. EPROM-Anordnung gemäß Anspruch 1 oder 2, wobei die dicken Oxidelemente (260) eine Dicke von 100 - 200 nm haben.

4. EPROM-Anordnung gemäß Anspruch 1, 2 oder 3, und die auch Abstandshalter (268) neben den ersten Polysiliziumstreifen bzw, -spalten enthält.

5. Verfahren zur Herstellung von Isolations- bzw, Trenneinheiten einer EPROM-Anordnung mit abwechselnder virtueller Metallerdung, wobei die Anordnung EPROM-Bereiche und Steuerbereiche hat, wobei jeder Steuerbereich Auswähltransistoren und Isolations- bzw. Trenneinheiten aufweist, die zwischen benachbarten der Auswähltransistoren angeordnet sind, wobei das Yerfahren **dadurch gekennzeichnet ist, dass** es die Schritte aufweist:

a. Bereiche eines dicken Oxides (260) und Bereiche eines dünnen Oxides (84) werden in den Steuerbereichen abgeschieden;

b. mit einer Maske werden Streifen eines ersten Polysiliziums (150) über zumindest einen Teil von jedem der Bereiche des dicken Oxids und des dünnen Oxids abgelegt; und

c. die Bereiche dicken und dünnen Oxids werden gemäß der Maske geätzt, wodurch die Bereiche des dicken und des dünnen Oxids mit den Streifen des ersten Polysiliziums ausgerichtet werden.

6. Verfahren nach Anspruch 5, wobei der Schritt zum Ätzen mit einem Ätzverfahren durchgeführt wird, das eine Selektivität von 20:1 hat.

7. Verfahren nach Anspruch 5 oder 6, wobei der Bereich (260) eines dicken Oxids eine Dicke von 100 bis 200 nm hat.

8. Verfahren nach einem der Ansprüche 5, 6 oder 7, dass nach dem Schritt des Ätzens den Schritt des Ablegens eines Abstandshalters (268) am nächsten zu den Streifen des ersten Polysiliziums enthält.

**Revendications**

1. Matrice de mémoire morte programmable électriquement (EPROM) à masse virtuelle métallique alternée comprenant :

   a. une première pluralité de zones d'EPROM (180) ; et

   b. une seconde pluralité de zones de commande (182), deux par zone d'EPROM (180), chaque zone de commande comprenant au moins une ligne et chaque ligne comprenant :

       i. une pluralité de premières bandes de polysilicium (80) s'étendant dans une première direction ; et

       ii. une seconde bande de polysilicium (82) reposant sur le dessus desdites premières bandes de polysilicium (80) mais s'étendant dans une seconde direction, perpendiculaire à la première direction ;

   **caractérisée en ce que** des éléments à couche d'oxyde épais (260) et des éléments à couche d'oxyde mince (84) sont agencés au-dessous desdites premières bandes de polysilicium (80) et automatiquement alignés sur ces dernières, les éléments à couche d'oxyde épais (260) alternant avec les éléments à couche d'oxyde mince (84) dans la seconde direction ; **en ce que** les éléments à couche d'oxyde mince (84) et les premières (80) et seconde (82) bandes de polysilicium forment un transistor de sélection (112, 114, 116) et **en ce que** les éléments à couche d'oxyde épais (260) et les premières (80) et seconde (82) bandes de polysilicium forment une unité d'isolation à couche d'oxyde épais automatiquement alignée (254).

2. Matrice EPROM comprenant :

   a. une pluralité de colonnes comprenant chacune :

   b. deux colonnes de polysilicium (80) d'une première couche de polysilicium ;

   c. une source virtuelle (S) alignée entre lesdites deux premières colonnes de polysilicium (80) ;

   d. dans une zone d'EPROM, une pluralité de lignes de second polysilicium (82) reposant sur le dessus desdites premières colonnes de polysilicium (80), et formant, aux intersections de ces dernières avec 5 lesdites premières colonnes de polysilicium (80), un premier groupe et un second groupe de transistors d'EPROM (52), dans lesquels chaque transistor d'EPROM (52), dans lesdits premier et second groupes, est relié à ladite source virtuelle (S) ;

   e. au moins une zone de commande comprenant deux lignes, chaque ligne comprenant une couche de second polysilicium (82) reposant sur le dessus desdites premières colonnes de polysilicium (80) et perpendiculaire à ces dernières ;

   **caractérisée en ce que** des éléments à couche d'oxyde épais (260) et des éléments à couche d'oxyde mince (84) sont agencés au-dessous desdites premières colonnes de polysilicium (80) et automatiquement alignés sur ces dernières, les éléments à couche d'oxyde épais (260) alternant avec les éléments à couche d'oxyde mince (84) dans une première direction ; **en ce que** l'intersection desdits éléments à couche d'oxyde épais (260) et desdites premières colonnes de polysilicium (80) et du second polysilicium (82) forme des unités d'isolement à couche d'oxyde épais automatiquement alignées (254) ; **en ce que**, à l'intersection avec les éléments à couche d'oxyde mince (84), lesdites premières colonnes de polysilicium (80) et une rangée particulière (SELn) dudit second polysilicium dans la zone de commande forment des premiers transistors de sélection (62), lesdits premiers transistors de sélection étant reliés entre ladite source virtuelle (S) et une première ligne de bits qui fonctionne en tant que drain pour ledit premier groupe de transistors d'EPROM, mais en tant que source pour ledit second groupe de transistors d'EPROM ; **en ce que**, à l'intersection des éléments à couche d'oxyde mince (84), lesdites premières colonnes de polysilicium (80) et l'autre ligne (SEL(n + 1)) dudit second polysilicium dans la zone de commande forment des seconds transistors de sélection (62), leadits seconds transistors de sélection étant reliés entre ladite source virtuelle et une seconde ligne de bits qui fonctionne comme un drain pour ledit second groupe de transistors d'EPROM, mais en tant que source pour ledit premier groupe de transistors d'EPROM ; et **en ce que** lesdits premiers et seconds transistors de sélection (62) sont agencés de sorte que le second transistor de sélection (62) agit comme un transistor de commande pour chacun des transistors d'EPROM (52) dans ledit premier groupe de transistors d'EPROM et de sorte que le premier transistor de sélection (62) agit comme un transistor de commande pour chacun des transistors d'EPROM (52) dans ledit second groupe de transistors d'EPROM.

3. Matrice EPROM selon la revendication 1 ou 2, dans laquelle lesdits éléments à couche d'oxyde épais (260) ont une épaisseur de 100 à 200 nm.

4. Matrice EPROM selon la revendication 1, 2 ou 3 et comprenant également des butées d'espacement (268) respectivement à côté desdites premières bandes ou colonnes de polysilicium.

5. Procédé de fabrication d'unités d'isolation d'une matrice EPROM à masse virtuelle métallique alternée, ladite matrice ayant des zones d'EPROM et des zones de commande, chaque zone de commande comprenant des transistors de sélection et des unités d'isolation situées entre des transistors voisins des transistors de sélection, le procédé étant **caractérisé en ce qu'**il comprend les étapes consistant à :

   a. déposer des zones à couche d'oxyde épais (260) et des zones à couche d'oxyde mince (84) dans lesdites zones de commande ;
   b. avec un masque, étendre des bandes de premier polysilicium (150) sur au moins une partie de chacune desdites zones à couche d'oxyde épais et à couche d'oxyde mince ; et
   c. graver lesdites zones à couche d'oxyde épais et à couche d'oxyde mince selon ledit masque pour aligner de ce fait lesdites zones à couche d'oxyde épais et à couche d'oxyde mince avec lesdites bandes de premier polysilicium.

6. Procédé selon la revendication 5 et dans lequel ladite étape de gravure est effectuée par un processus de gravure ayant une sélectivité de 20 / 1.

7. Procédé selon la revendication 5 ou 6, dans lequel ladite zone à couche d'oxyde épais (260) a une épaisseur de 100 à 200 nm.

8. Procédé selon la revendication 5, 6 ou 7 comprenant, après l'étape de gravure, l'étape consistant à déposer une butée d'espacement (268) à côté desdites bandes de premier polysilicium.

FIG.1A
PRIOR ART

FIG.1B
PRIOR ART

14

FIG.2
PRIOR ART

FIG.3
PRIOR ART

FIG.4A
PRIOR ART

FIG.4B
PRIOR ART

FIG. 5A

FIG. 5B

EP 0 673 071 B1

FIG. 6

FIG. 7

FIG. 8

FIG. 9 A

FIG. 9 B

FIG. 9 C

EP 0 673 071 B1

FIG. 9D

FIG. 9E

FIG. 10